# EUROPEAN PATENT APPLICATION

(11) **EP 2 213 454 A2**
(43) Date of publication of application: **04.08.2010**
(21) Application number: 09015569.8
(22) Date of filing: 16.12.2009
(51) Int. Cl.: B41F 15/18, B41F 15/46, H05K 3/12, H05K 3/34, H05K 13/00

(54) **Substrate supporting device and screen printer**

(30) Priority: 18.12.2008 JP 2008323008
(71) Applicant: Hitachi High-Tech Instruments Co., Ltd., Ora-gun, Gunma, 370-0596 (JP)
(72) Inventor: Nishi, Noboru, Himeji-shi, Hyogo (JP); Hineno, Kazuhiro, Ora-gun, Gunma (JP); Komatsu, Ryuichi, Ora-gun, Gunma (JP); Tomizawa, Yoshio, Ota-shi, Gunma (JP)
(74) Representative: Glawe, Delfs, Moll

(57) **Abstract**

This invention is directed to eliminating work to extract and insert pins by a worker, automating selection of the pins in a substrate supporting device, reducing the time required to select the pins, and avoiding a delay in printing with a screen printer. The substrate supporting device is provided with a supporting block (51) to support the supporting pins (52), upper and lower air supply conduits (58, 59) to lift and lower the supporting pins (52), a supporting pin base (81) that is movable relative to the supporting pins (52) and supports the lifted supporting pins (52) from below, and a push-in head (87) that is movable vertically and pushes-in desired one of the supporting pins (52).

## Description

### Field of the Invention:

This invention relates to a substrate supporting device provided with a plurality of supporting pins to support a printed circuit board and a screen printer that applies an applying material on a screen to the printed circuit board supported by the supporting pins of the supporting device by moving a squeeze.

### Description of the Related Art:

This kind of screen printer is disclosed in Japanese Patent Application Publication No. 2000-211108, for example, and is provided with a θ axis base that is placed approximately horizontally, a shaft bearing that allows the θ axis base to pivot around a central axis of the θ axis base in an approximately horizontal plane, a plurality of θ axis base supporting mechanisms that supports a periphery of a bottom surface of the θ axis base so as to allow the θ axis base freely sliding, and a substrate supporting mechanism placed on the θ axis base. A backup mechanism (substrate supporting device) located above the substrate supporting mechanism is formed of a plate and a plurality of pins attached into some of holes formed in the plate.

The backup mechanism described above requires changing locations of the pins in accordance with a type of substrate to be printed, which causes a problem that a worker is required to do a complicated work when he makes extraction and insertion of the pins from and to the plate, for example. Particularly when a large number of pins are subject to the work, the work becomes increasingly complicated to take more time, causing a problem that a printing work with the screen printer is delayed.

A setting mechanism of lower supporting pins that are supporting pins provided for solving the problem in the work to extract and insert the pins by the worker and the problem of the increased time required to do the work is disclosed in Japanese Patent Application Publication No. H05-335800, for example. The setting mechanism is provided with printed circuit board lower supporting means that is lower supporting pins stored in through-holes so as to be capable of protruding by moving vertically and two-dimensionally arrayed in X and Y directions at predetermined intervals, a selecting means that is an array of selection pins disposed in the X direction and being driven based on a control signal so as to protrude the lower supporting pin, a setting means that is a plurality of setting boards arrayed in the Y direction so as to correspond to all the lower supporting pins and interposed between the printed circuit board lower supporting means and the selecting means, the setting board having a one-dimensional array of through-holes disposed in the X direction, the through-holes being formed to allow the selection pins to butt against the lower supporting pins, a driving means to drive the lower supporting means and the setting means all together in the Y direction at predetermined intervals, and a setting board driving means to drive the setting board in the X direction. The setting mechanism sets whether the lower supporting pins are protruded or not protruded.

With the mechanism to set the lower supporting pins of the printed circuit board described in Japanese Patent Application Publication No. H05-335800, however, the number of times to drive the lower supporting means and the setting means all together in the Y direction at predetermined intervals is increased and the time required for the setting is increased, particularly when a large number of pins are subject to the work, causing a problem that the printing with the screen printer is delayed.

It is an object of this invention to eliminate the work to extract and insert the pins by the worker, automate the selection of the pins, reduce the time required to select the pins, and avoid the delay in the printing with the screen printer.

### SUMMARY OF THE INVENTION

The solution according to the invention resides in the features of the independent claims and preferably in those of the dependent claims.

This invention provides a substrate supporting device (24) having a plurality of supporting pins (52) to support a printed circuit board (P), a supporting block (51) to support the supporting pins (52), a vertical movement device (60a) to move the supporting pins (52) vertically, a supporting base (81) to support the supporting pins (52) moved upward by the vertical movement device (60a) from below, the supporting base (81) being movable relative to the supporting pins (52), and a push-in device (87) to push-in a desired one of the supporting pins (52) into the supporting block (51) by descending, the push-in device being movable vertically.

Also, this invention provides a screen printer having a plurality of supporting pins (52) to support a printed circuit board (P), a screen (S) with patterned holes formed therein, and a squeeze (33A, 33B) to apply an applying material on the screen (S) to the printed circuit board (P) through the patterned holes by moving, and a substrate supporting device (24) having a supporting block (51) to support the supporting pins (52), a vertical movement device (60a) to move the supporting pins (52) vertically, a supporting base (81) to support the supporting pins (52) moved upward by the vertical movement device (60a) from below, the supporting base (81) being movable relative to the supporting pins (52), and a push-in device (87) to push-in a desired one of the supporting pins (52) into the supporting block (51) by descending, the push-in device (87) being movable vertically.

With the substrate supporting device and the screen printer according to the embodiments of this invention, the work to extract and insert the pins by the worker can be eliminated, the time required to select the pins can be reduced as well as automating the selection of the pins in the substrate supporting device, and the delay in the printing with the screen printer can be avoided.

### BRIEF DESCRIPTION OF THE DRAWINGS

Fig. 1 is a front view showing a screen printer according to an embodiment of this invention.
Fig. 2 is a right side view showing a principal portion of the screen printer according to the embodiment of this invention.
Fig. 3 is a cross-sectional view showing a portion of a substrate supporting device according to an embodiment of this invention.
Fig. 4 is a plan view showing the substrate supporting device according to the embodiment of this invention.
Fig. 5 is a cross-sectional view showing a portion of the substrate supporting device according to the embodiment of this invention.
Fig. 6 is a cross-sectional view showing a portion of the substrate supporting device according to the embodiment of this invention.
Fig. 7 is a cross-sectional view showing a portion of the substrate supporting device according to the embodiment of this invention.
Fig. 8 is a cross-sectional view showing a portion of the substrate supporting device according to the embodiment of this invention.
Fig. 9 is a cross-sectional view showing a portion of the substrate supporting device according to the embodiment of this invention.
Fig. 10 is a cross-sectional view showing a portion of the substrate supporting device according to the embodiment of this invention.
Fig. 11 is a cross-sectional view showing a portion of the substrate supporting device according to the embodiment of this invention.
Fig. 12 is a cross-sectional view showing a portion of a substrate supporting device according to another embodiment of this invention.
Fig. 13 is a cross-sectional view showing a portion of the substrate supporting device according to the another embodiment of this invention.

### DETAILED DESCRIPTION OF THE INVENTION

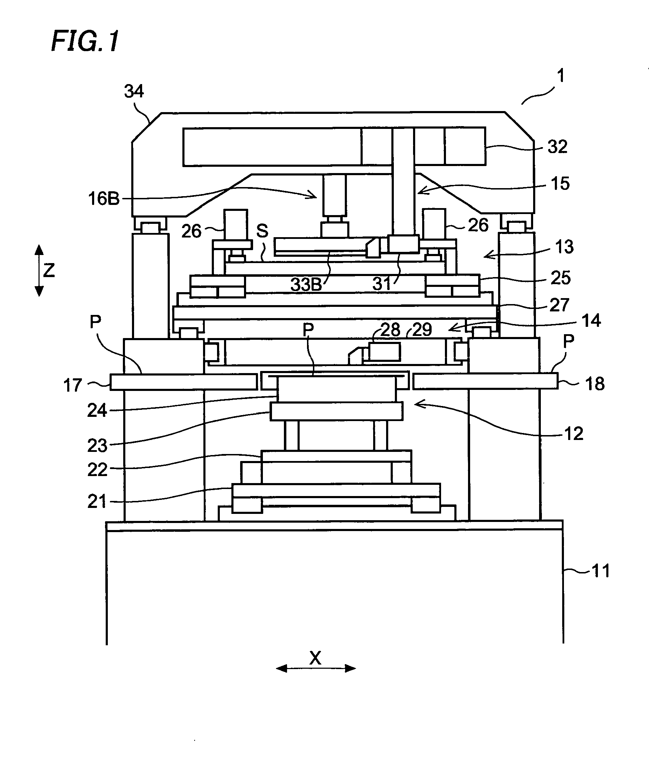

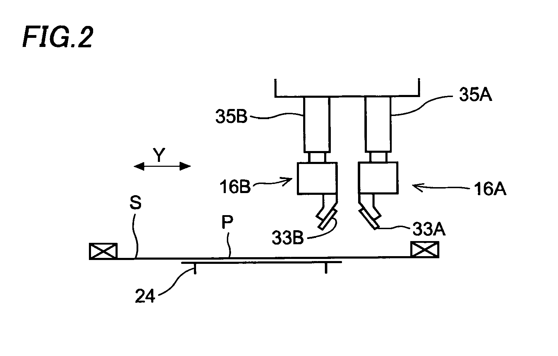

Substrate supporting devices and a screen printer according to embodiments of this invention are hereafter described, referring to the drawings. Fig. 1 is a front view showing a principal portion of the screen printer 1. Fig. 2 is a right side view showing a principal portion of the screen printer 1.

The screen printer 1 is provided with a substrate supporting table 12 placed on a base 11, a screen supporting means 13 placed above the substrate supporting table 12, a first imaging means 14 to pick up images of substrate recognition marks KM attached to diagonal locations on a printed circuit board P that is placed between the substrate supporting table 12 and the screen supporting means 13 and supported by the substrate supporting table 12, a second imaging means 15 to pick up an image of a screen recognition mark attached to a screen S that is placed above the screen supporting means 13 and supported by the screen supporting means 13, a pair of printing heads 16A and 16B (Refer to Fig.2.) placed above the screen S, a carrying-in conveyer 17 to carry-in the substrate P onto the substrate supporting table 12, a sending-out conveyer 18 to send the substrate P out from above the substrate supporting table 12, and a monitor (not shown) that shows the images picked up by the first and second imaging means 14 and 15, as shown in Fig. 1.

The substrate supporting table 12 is provided with a first transfer mechanism 21 to move along an X axis extending in a horizontal direction (Refer to Fig. 1.), a rotation mechanism 22 that is placed on the first transfer mechanism 21 and rotates in a horizontal plane, a second transfer mechanism 23 that is placed on the rotation mechanism 22 and moves along a Z axis extending in a vertical direction, a substrate supporting device 24 that is placed on the second transfer mechanism (hereafter referred to as a block base) 23 and provided with a plurality of supporting pins to be described, blocks to support the supporting pins and the like, and a transfer mechanism (not shown) that is placed on the substrate supporting device 24 and transfers the substrate P along the X axis.

The screen supporting means 13 is provided with a screen supporting frame 25 to support a periphery of a lower surface of the screen S, cylinders 26 that are placed above the screen supporting frame 25 and press the screen S to the screen supporting frame 25, and a transfer mechanism 27 to move along a Y axis extending in a horizontal direction.

The first imaging means 14 is provided with a substrate recognition camera 28, a transfer mechanism 29 to transfer the substrate recognition camera 28 in directions along the X axis and the Y axis, and a lighting device (not shown) to illuminate the substrate P on the substrate supporting table 12. The second imaging means 15 is provided with a screen recognition camera 31, a transfer mechanism 32 to transfer the screen recognition camera 31 in the direction along the X axis, and a lighting device (not shown) to illuminate the substrate P on the substrate supporting table 12. The screen recognition camera 31 is transferred in the direction along the Y axis by a transfer mechanism 34 of the printing heads 16A and 16B.

The printing heads 16A and 16B are placed along the Y axis and separated from each other, and each of squeezes 33A and 33B is attached to a lower end of each of the printing heads 16A and 16B, respectively, as shown in Fig. 2. The printing heads 16A and 16B are transferred simultaneously in the direction along the Y axis by the transfer mechanism 34, while each of them is transferred independently in the direction along the Z axis by each of vertical transfer mechanisms 35A and 35B, respectively. When the printing heads 16A and 16B move to the left in Fig. 2, the printing head 16A on the right side descends and the squeeze 33A slides on the screen S. When the printing heads 16A and 16B move to the right in Fig. 2, the printing head 16B on the left side descends and the squeeze 33B slides on the screen S. Therefore, printing is performed twice while the printing heads 16A and 16B make a round trip.

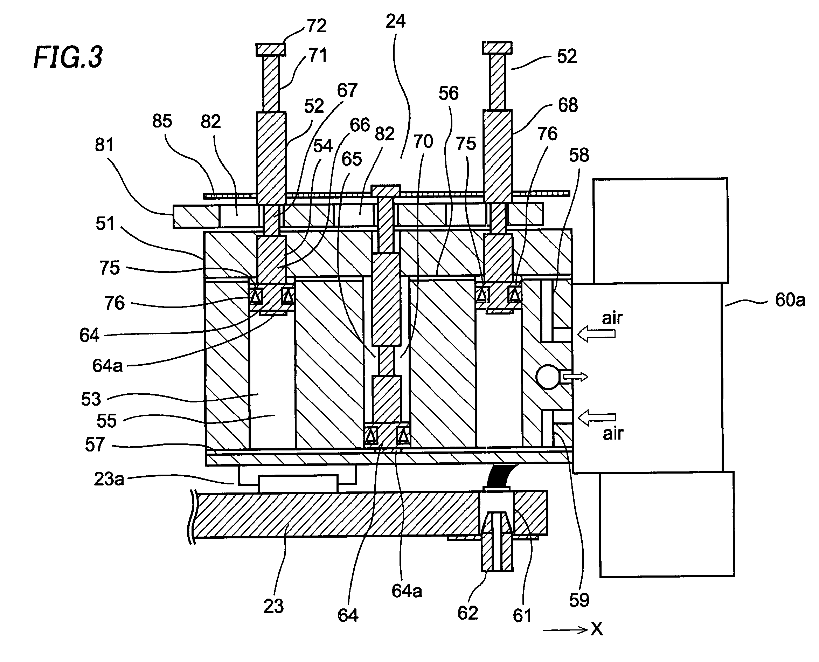

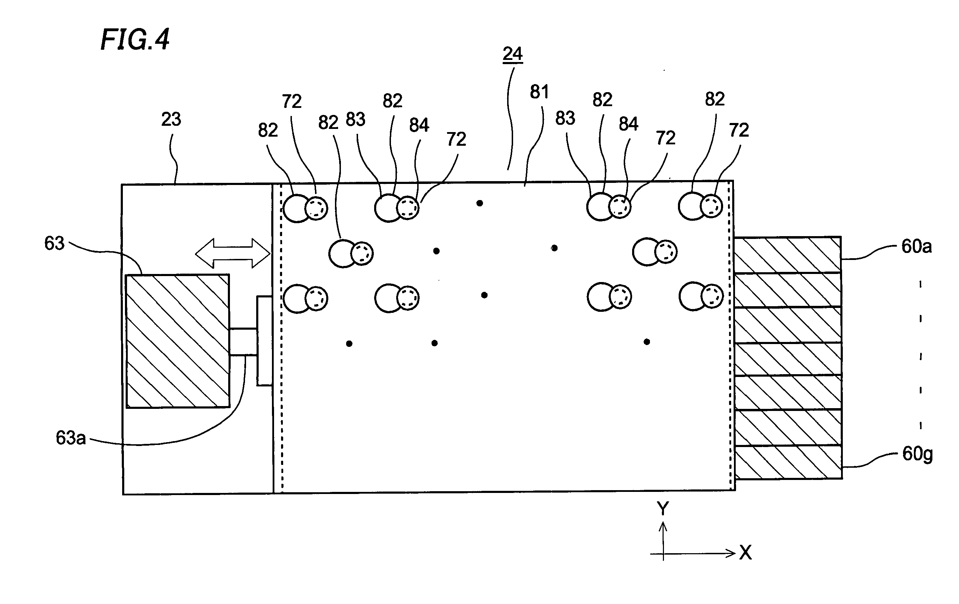

The substrate supporting device 24 is hereafter described in detail referring to Figs. 3 and 4.

A plurality of rows (X direction in Figs. 3 and 4) and a plurality of columns (Y direction in Fig. 4) of supporting holes 53, each supporting each of supporting pins 52, respectively, is formed in a supporting block 51. Each of the supporting holes 53 is made of an upper hole 54 that is formed in an upper portion of the supporting block 51 and supports the supporting pin 52 so as to allow the supporting pin 52 sliding up and down freely and a lower hole 55 that is formed below the upper hole 54 and is larger than the upper hole 54 in a cross-sectional area. Upper air supply conduits 56, each communicating with upper portions of the lower holes 55 in each of the rows respectively, and lower air supply conduits 57, each communicating with lower portions of the lower holes 55 in each of the rows respectively, are in the supporting block 51. The upper air supply conduit 56 and the lower air supply conduit 57 in each of the rows communicate with an upper suction path 58 and a lower suction path 59, respectively. An inlet of the upper suction path 58 and an inlet of the lower suction path 59 in each of the rows are connected to corresponding each of open-center type 5 port solenoid valves 60a-60g,for example, that are attached on a side surface of the supporting block 51 in line.

Linear guides 23a are provided at a plurality of locations between the supporting block 51 and the block base 23, and support the supporting block 51 so as to be able to slide freely on the block base 23 in a horizontal direction (direction X in Fig. 3). A connection hole 61 is formed in the block base 23 near the solenoid valves 60a-60g. An air supply pipe 62 connected with an air supply (not shown) is connected to a bottom of the connecting hole 61, and a top of the connecting hole 61 is connected to each of the solenoid valves 60a-60g through piping.

A driving cylinder 63 to move the supporting block 51 in the X direction (direction indicated by an arrow in Fig. 4) is provided on the block base 23. A rod 63a of the driving cylinder 63 is connected to a side surface of the supporting block 51 on the opposite side to the solenoid valves 60a-60g.

The supporting pin 52 has a circular cross-section and its lower portion forms a sliding portion 64 that is largest in diameter and slides up and down in the lower hole 55. A protruded portion 64a that is smaller in diameter than the sliding portion 64 is formed under the sliding portion 64, while a constricted portion 65 that is smaller in diameter than the sliding portion 64 is formed above the sliding portion 64. The constricted portion 65 includes a lower intermediate portion 66 that is slightly smaller in diameter than the upper hole 54 and approximately fits into the upper hole 54 when the supporting pin 52 moves upward, a central portion (constriction) 67 that is formed above the lower intermediate portion 66 and smaller in diameter than the lower intermediate portion 66, and an upper intermediate portion 68 that is formed above the central portion 67 and has the same cross-sectional shape as the lower intermediate portion 66. There is formed a space 70 between the constricted portion 65 and a sidewall of the lower hole 55 when the supporting pin 52 is in a descended state.

An extended portion 71 that is equal in diameter to the central portion 67 and smaller in cross-sectional area than the upper intermediate portion 68 and extending further upward is formed above the constricted portion 65. An upper end portion 72 that is larger in diameter than the extended portion 71 is formed above the extended portion 71.

The sliding portion 64, the constricted portion 65, the extended portion 71 and the upper end portion 72 are formed as a single piece, for example. A groove 75 is formed around a side surface of the sliding portion 64, and a packing 76 is placed in the groove 75. The packing 76 is inverted U-shaped, for example, so that resistance is greater when the sliding portion 64, i. e. the supporting pin 52 moves downward than when it moves upward.

A plurality of rows and a plurality of columns of through-holes 82, each corresponding to each of the supporting pins 52, are formed in a supporting pin base 81 that is formed above the supporting block 51 with a space in-between. Each of the through-holes 82 is shaped in two overlapping eccentric circles in a plan view shown in Fig. 4, and has a hoisting portion 83 having a diameter large enough for the upper intermediate portion 68 to move up and down in it, and a supporting portion 84 formed contiguous to the hoisting portion 83 and having a diameter small enough to support a lower end of the upper intermediate portion 68 when the supporting pin 52 in an ascended state. Note that not all the through-holes 82 are shown in Fig. 4.

A sheet 85 to shelter from dust is provided above the supporting pin base 81. A plurality of holes 86, each corresponding to each of the supporting pins 52 respectively, is formed in the sheet 85. The sheet 85 is attached to the supporting block 51 through an attaching mechanism (not shown) and moves along with the supporting block 51 as the supporting block 51 moves.

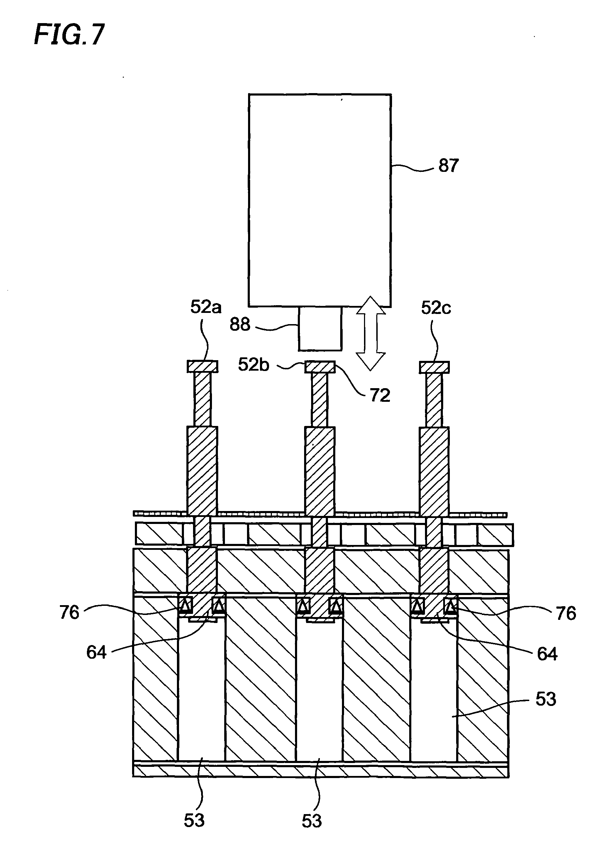

A push-in head 87, that is a cylinder, for example, and movable in horizontal directions or X and Y directions, for example, is provided above the supporting block 51 as shown in Fig. 7. The push-in head 87 is provided with a rod 88 that is movable in vertical direction to push a pre-assigned supporting pin 52 into one of the supporting holes 53 as it descends.

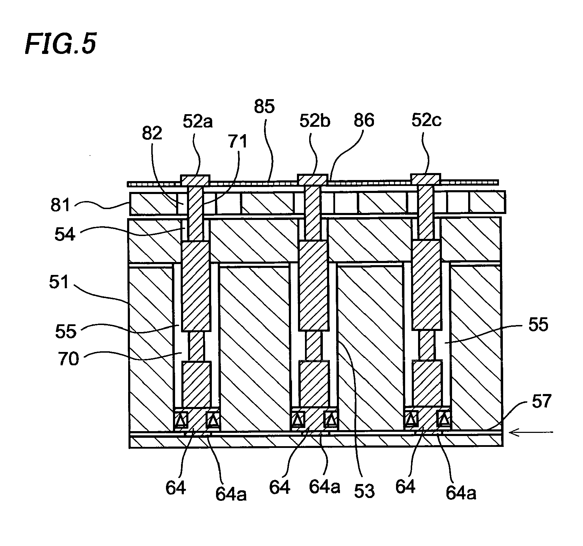

Operations in setting each of the supporting pins 52 in accordance with the substrate P to be printed are described below, referring to Figs. 3-11. The supporting pins 52 shown in Figs. 5-11 are labeled with 52a, 52b and 52c from left to right, respectively, in order to distinguish from each other. The same components as those shown in Figs. 3 and 4 are denoted by the same symbols and detailed explanations on them are omitted.

In an initial state before commencing the setting of supporting the substrate P by the supporting pins 52a, 52b and 52c, each of the supporting pins 52a, 52b and 52c is at a descended position, the sliding portion 64 is located at a bottom portion of the lower hole 55, the protruded portion 64a makes contact with the bottom of the lower hole 55, the constricted portion 65 is located in the lower hole 55 except for an upper portion of the upper intermediate portion 68, and the space 70 is formed between each of the supporting pins 52a, 52b and 52c and the sidewall of the lower hole 55. The upper portion of the upper intermediate portion 68 is located in the upper hole 54. The through-hole 82 is located above the upper hole 54, the extended portion 71 penetrates through the through-hole 82, and the upper end portion 72 is located in the hole 86 in the sheet 85. In the initial state as described above, the solenoid valves 60a-60g are put into operation when a control device (not shown) such as a CPU (Central Processing Unit) send an open signal to the solenoid valves 60a-60g. Air is sent from the air supply through the solenoid valve 60a, for example, to the lower air supply conduit 57 in a corresponding row as depicted by an arrow, and each of the sliding portions 64 is pressed from below to lift each of the supporting pins 52a, 52b and 52c.

As a result, each of the supporting pins 52a, 52b and 52c is lifted to and stops at an uppermost position where an upper surface of the sliding portion 64 makes contact with an upper surface of the lower hole 55. At that time, the lower intermediate portion 66 is approximately fits into the upper hole 54, each of the supporting pins 52a, 52b and 52c is supported by an upper portion of the supporting block 51, and the central portion 67 is at a location corresponding to the through-hole 82. The air in the supporting hole 53 is prevented from leaking by the packing 76 in the sliding portion 64 of each of the supporting pins 52a, 52b and 52c, and each of the supporting pins 52a, 52b and 52c is held at the ascended position by friction between the packing 76 and the sidewall of the supporting hole 53 even when the supply of the air through the lower air supply conduit 57 is halted.

Since the packing 76 is inverted U-shaped and the resistance is greater when the sliding portion 64 moves downward than when it moves upward as described above, each of the supporting pins 52a, 52b and 52c can be lifted with smaller air pressure and can be kept in the ascended state even more securely.

Next, the supply of the air through the lower air supply conduit 57 is halted, and the rod 88 of the push-in head 87 that has been moved above the supporting pin 52b that is pre-assigned as one of pins not required to support the printed circuit board P (hereafter referred to as pins not required supporting) is lowered, as shown in Fig. 7.

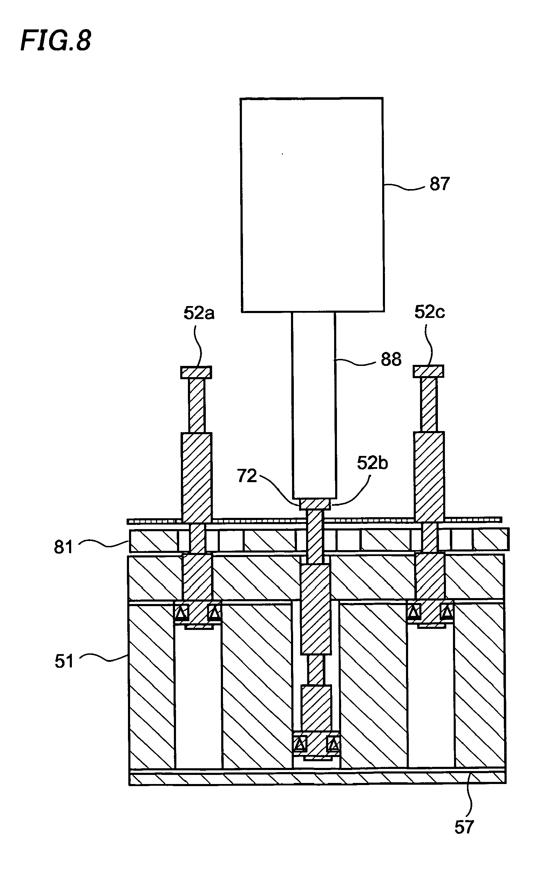

As a result, a lower end of the rod 88 makes contact with the upper end portion 72 of the supporting pin 52b by its descend and the supporting pin 52b is lowered and pushed into the supporting block 51 and the supporting pin base 81, as shown in Fig. 8. After that, the push-in head 87 moves to above another pin not required supporting, and pushes it into the supporting block 51 and the supporting pin base 81 in the same way. When the supporting pin is pushed-in, the air in the lower hole 55 and the lower air supply conduit 57 is released into the atmosphere through the solenoid valve so that the supporting pin can be smoothly pushed-in.

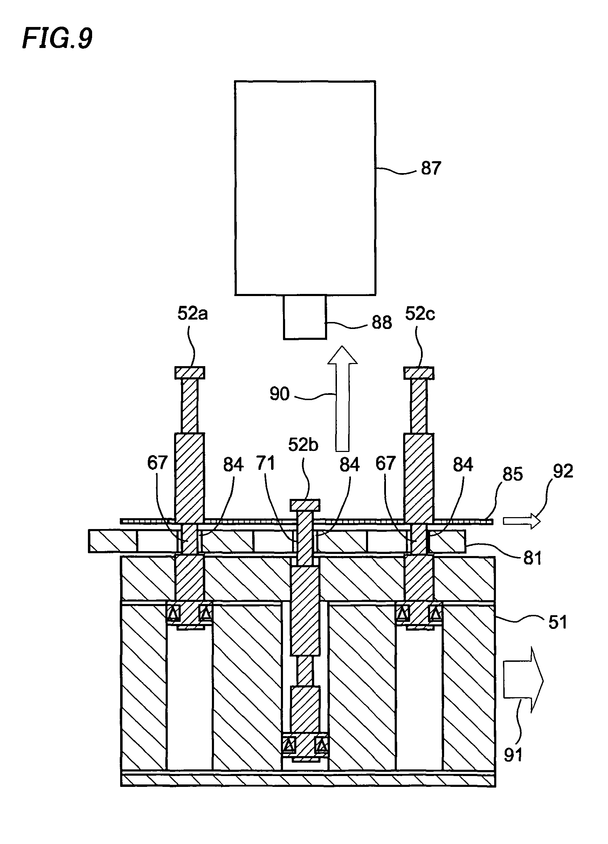

After all the pins not required supporting are pushed-in, the rod 88 ascends as indicated by an arrow 90 in Fig. 9, and is held in that state. The supporting pins 52a and 52c to be used in supporting the printed circuit board P and shown in the drawings are held in the ascended state. Next, the driving cylinder 63 is put into operation to extend the rod 63 and move the supporting block 51 and the sheet 85 gradually in a direction indicated by arrows 91 and 92. As a result of the movement, the central portions 67 of the supporting pins 52a and 52c, that is, the central portions 67 of the pins to be used in supporting the printed circuit board P move from the hoisting portion 83 to the supporting portion 84 in the through-hole 82. The extended portion 71 of the supporting pin 52b, that is, the extended portion 71 of the pin not required supporting, is also moved from the hoisting portion 83 to the supporting portion 84.

Since the supporting pins 52a, 52b and 52c are formed so that the central portion 67 and the extended portion 71 that are small in diameter are aligned to the supporting portions 84 when they are in the ascended state or in the descended state, the central portion 67 and the extended portion 71 can be moved from the hoisting portion 83 to the supporting portion 84 both in the ascended state and in the descended state by moving the supporting block 51.

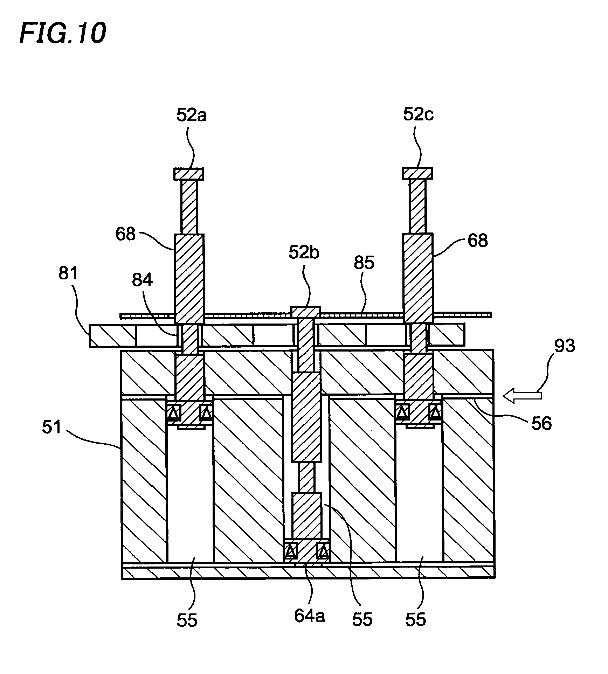

After the supporting block 51 and the sheet 85 completes the movement, the solenoid valves 60a-60g are put into operation so that the air is supplied from the air supply to the upper air supply conduit 56 through the solenoid valves 60a-60g as indicated by an arrow 93 shown in Fig. 10. Thus, the supporting pins 52a and 52c to be used in supporting are slightly lowered approximately simultaneously by the pressure of the air so that a lower end of the upper intermediate portion 68 makes contact with an upper surface of a periphery of the supporting portion 84 of the supporting pin base 81 and held in that position, as shown in Fig. 10. At that time, the central portion 67 of the supporting pins 52a and 52c to be used in the supporting may be fitted into the supporting portion 84.

Since the lower end of the upper intermediate portion 68 of each of the supporting pins 52a, 52c and the like makes contact with the upper surface of the periphery of the supporting portion 84 of the supporting base 81 and the supporting pins 52a, 52c and the like are held in that position, all the supporting pins to be used in the supporting including the supporting pins 52a and 52c can be positioned simultaneously at the same height by the supporting pin base 81. The supporting pins not to be used in the supporting such as the supporting pin 52b are slightly lowered so that the protruded portion 64a makes contact with the bottom of the lower hole 55 to be supported and positioned.

When the supporting pins 52a and 52c and the like are set at supporting positions of the printed circuit board P, that is, when they are positioned, time required in setting the supporting pins can be reduced since the supporting pins are positioned by simultaneous ascending or descending using the driving means as described above.

The setting of the supporting pins is performed similarly on the supporting pins in each of the rows corresponding to each of the solenoid valves 60b-60g, respectively. The supporting pins in each of the rows to be used in supporting the printed circuit board P are positioned and set.

Therefore, when the supporting pins to be used in the supporting such as the supporting pins 52a and 52c are set at the supporting positions of the printed circuit board P, the setting of the necessary supporting pins can be set without worker's operation. When a large number of supporting pins are set, time required in the setting can be substantially reduced.

After the supporting pins to be used in supporting the printed circuit board P such as the supporting pins 52a and 52c and the supporting pins not to be used in the supporting such as the supporting pin 52b are positioned accordingly, the printing operation on the printed circuit board P is performed as described above.

After the printing on a plurality of the printed circuit boards P is completed for example, a tooling change to set the supporting pins for the next printed circuit board P to be printed is performed.

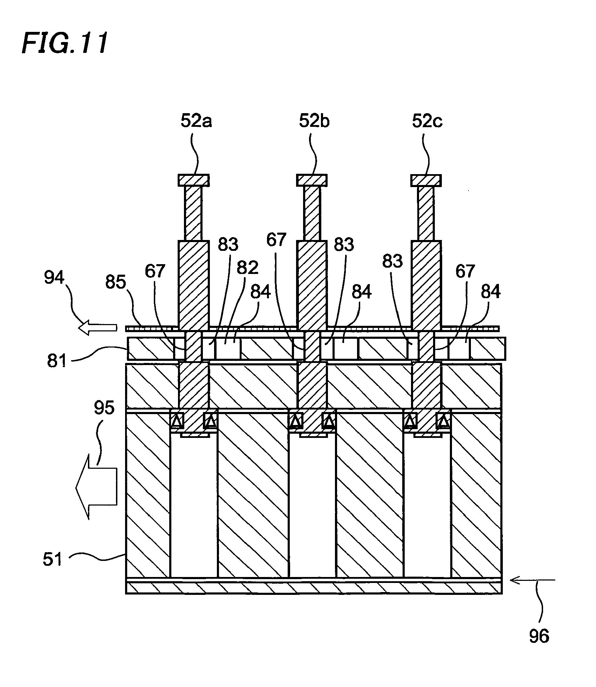

In the tooling change, the driving cylinder 63 is put into operation to pull-in the rod 63a and move the supporting block 51 and the sheet 85 gradually in a direction indicated by arrows 94 and 95. As a result of the movement, the supporting pins 52a, 52b and 52c, that is, all the supporting pins are aligned to hoisting portions 83 of the through-holes 82, as shown in Fig. 11. After that, the air flows into the lower air supply conduit 57 through the solenoid valves 60a-60g, as indicated by an arrow 96. Thus, all the supporting pins 52a, 52b, 52c · · · are lifted.

As a result, the central portions 67 of the supporting pins 52a, 52b and 52c, that is, of all the supporting pins, are aligned to the hoisting portions 83 of the through-holes 82, as shown in Fig. 11.

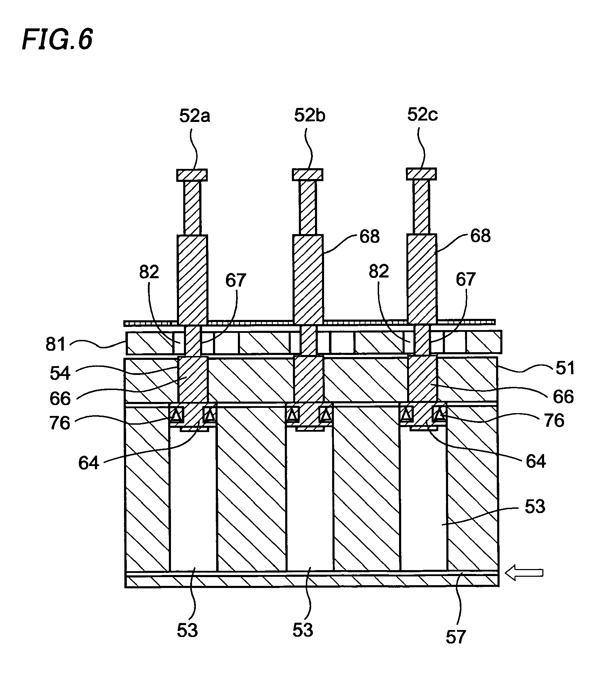

Relative locations among the supporting pins 52a, 52b, 52c, the supporting block 51, the supporting pin base 81 and the sheet 85 shown in Fig. 11 are identical to those shown in Fig. 6. Subsequent setting of the supporting pins to be used is performed in the same way as described above.

The solenoid valves 60a-60g are on/off-controlled based on the size of the printed circuit board to be printed. The solenoid valves not related to the printed circuit board to be supported may be arrange so as not to be put into operation so that supplying the air to unnecessary supporting block 51 and lifting/lowering unnecessary supporting pins can be avoided.

A setting method of supporting pins of a substrate supporting device in a screen printer according to another embodiment of this invention is described hereafter referring to the drawings.

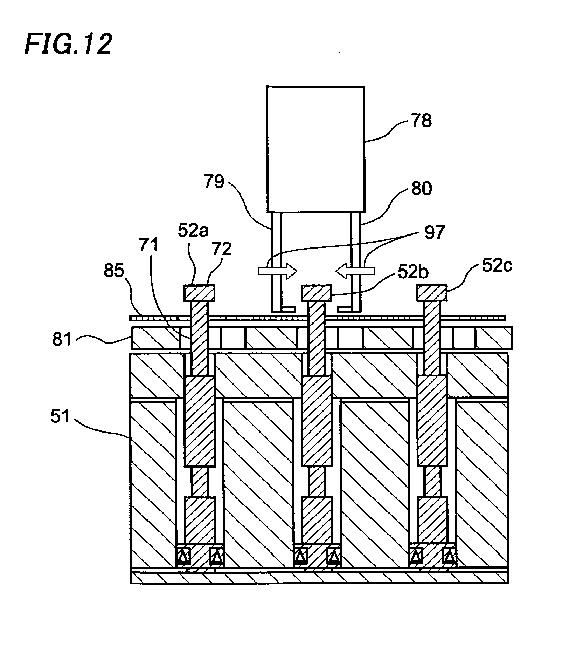

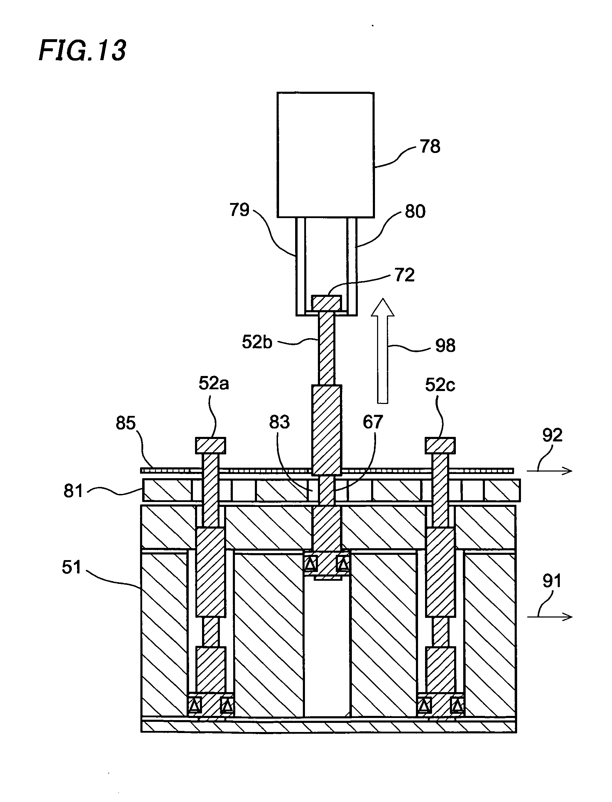

Figs. 12 and 13 are cross-sectional views showing a portion of the substrate supporting device in the screen printer. The same components in Figs. 12 and 13 as those in the embodiment described above are denoted by the same symbols and detailed explanations on them are omitted.

Fig. 12 shows an initial state of setting of supporting pins 52a, 52b and 52c in the substrate supporting device in the printer that is provided with a gripping head 78. The gripping head 78 is movable in X and Y directions or in horizontal directions, for example, as the push-in head 87, and is movable in a vertical direction by a lifting/lowering mechanism (not shown). A pair of gripping claws 79 and 80 that moves in the horizontal directions is attached to a lower portion of the gripping head 78. An extended portion 71 of each of the supporting pins 52a, 52b and 52c is slightly longer than that in the embodiment described above, and an upper portion of the extended portion 71 and an upper end portion 72 are protruded upward from a sheet 85.

Fig. 12 shows the gripping head 78 in a descended position in which the gripping claws 79 and 80 of the gripping head 78 positioned above the supporting pin 52b to be used in supporting the printed circuit board move horizontally to come closer to each other as indicated by arrows 97. After hooking the upper end portion 72 of the supporting pin 52b with lower ends of the gripping claws 79 and 80, the gripping head 78 is lifted to a predetermined height to pull up the supporting pin 52b as indicated by an arrow 98 in Fig. 13. As a result, a central portion 67 of the supporting pin 52b is located in a hoisting portion 83. The gripping head 78 pulls up other supporting pins to be used in supporting the printed circuit board in the same way.

Next, a supporting block 51 and a sheet 85 are moved as indicated by arrows 91 and 92 in Fig. 9, and then the supporting pins to be used are positioned and set through the same operations as the setting operations from the state shown in Fig. 9 to the state shown in Fig. 10 in the embodiment described above.

As described above, the operations to set the supporting pins to be used can be further simplified when the gripping head 78 is used.

This invention is not limited to the embodiments described above, and includes various alternatives, corrections and modifications within the scope of the invention, which may be found by a person skilled in the art based on the explanations described above.

## Claims

1. A substrate supporting device comprising:
a plurality of supporting pins (52) to support a printed circuit board (P);
a supporting block (51) to support the supporting pins (52);
a vertical movement device (60a) to move the supporting pins (52) in a vertical direction;
a base (81) to support from below the supporting pins (52) lifted by the vertical movement device (60a), the supporting base (81) being movable relative to the supporting pins (52); and
a push-in device (87) to push-in desired one of the supporting pins (52) into the supporting block (51) by descending, the push-in device (87) being movable vertically.

2. The substrate supporting device of claim 1, wherein the supporting block (51) is provided with a plurality of supporting holes (53) to support the plurality of supporting pins (52), the vertical movement device (60a) is structured so as to be capable of lifting and lowering the plurality of supporting pins (52) simultaneously, and the push-in device (87) pushes-in one of the supporting pins (52) selected from among the plurality of supporting pins (52) lifted simultaneously by the vertical movement device (60a) into a corresponding one of the plurality of supporting holes (53).

3. The substrate supporting device of claim 1, wherein the base (81) supports the supporting pin (52) lifted by the vertical movement device (60a) by moving horizontally.

4. The substrate supporting device of claim 1, wherein the supporting block (51) is capable of sliding in a horizontal direction and comprises a plurality of supporting holes (53) to support the plurality of supporting pins (52) and air supply conduits (56, 57), each of the supporting holes (53) comprising an upper hole (54) and a lower hole (55), the upper hole (54) being formed in an upper portion of the supporting block (51) and supporting the supporting pin (52) so as to allow the supporting pin (52) to slide vertically, the lower hole (55) being formed below the upper hole (54) and larger than the upper hole (54) in a cross-sectional area, the air supply conduits (56, 57) communicating with an upper portion or a lower portion of the lower hole (55), wherein each of the supporting pins (52) comprises a sliding portion (64), a lower intermediate portion (66), a central portion (67), an upper intermediate portion (68) and an extended portion (71), the sliding portion (64) being disposed in a lower portion of the supporting pin (52) and configured to be able to slide vertically in the lower hole (55), the lower intermediate portion (66) being formed above the sliding portion (64) and smaller in cross-sectional area than the sliding portion (64), a space being formed between the lower intermediate portion (66) and a sidewall of the lower hole (55), the lower intermediate portion (66) sliding into the upper hole (54) when being lifted, the lower intermediate portion (66) being fitted to the upper hole (54), the central portion (67) being formed above the lower intermediate portion (66) and smaller in cross-sectional area than the lower intermediate portion (66), the upper intermediate portion (68) being formed above the central portion (67) and identical in cross-sectional shape to the lower intermediate portion (66), the extended portion (71) being formed above the upper intermediate portion (68) and smaller in cross-sectional area than the upper intermediate portion (68), and wherein the base (81) is disposed above the supporting block (51) and comprises a plurality of through-holes (82) formed so that each of the through-holes (82) corresponds to each of the supporting pins (52) respectively, each of the through-holes (82) comprising a hoisting portion (83) and a supporting portion (84), the hoisting portion (83) corresponding to the upper intermediate portion (68), the supporting portion (84) being formed continuous to the hoisting portion (83) and configured so as to support a lower end of the upper intermediate portion (68) when the supporting pin (52) is lifted.

5. The substrate supporting device of claim 2, further comprising a packing (76) disposed in a lower portion of the supporting pin (52) and making contact with a sidewall of the supporting hole (53) and an air supply providing a lower portion or an upper portion of the supporting hole (53) with air.

6. The substrate supporting device of claim 4, wherein the sliding portion (64) comprises a packing (76) making contact with a sidewall of the lower hole (55).

7. The substrate supporting device of claim 4, wherein the supporting block (51) and the base (81) are divided into divided supporting blocks (51) and divided bases (81), respectively, and each of the divided supporting blocks (51) is provided with each of the vertical movement devices (60a-60g) and the air supply conduits (56, 57).

8. The substrate supporting device according to any of claims 1 to 7, further comprising a sheet (85) disposed on the base (81) and having a plurality of through-holes (82) each corresponding to each of the supporting pins (52), respectively.

9. A screen printer comprising:
a plurality of supporting pins (52) supporting a printed circuit board (P);
a screen (S) with patterned holes;
a squeeze (33A, 33B) to apply an applying material on the screen (S) to the printed circuit board (P) through the patterned holes by moving; and
a substrate supporting device (24),
wherein the substrate supporting device (24) comprises a supporting block (51) to support the supporting pins (52);
a vertical movement device (60a) to move the supporting pins (52) in a vertical direction; a base (81) to support from below the supporting pins (52) lifted by the vertical movement device (60a), the supporting base (81) being movable relative to the supporting pins (52); and a push-in device (87) to push-in desired one of the supporting pins (52) into the supporting block (51) by descending, the push-in device (87) being movable vertically.

10. The screen printer of claim 9, wherein the supporting block (51) is provided with a plurality of supporting holes (53) to support the plurality of supporting pins (52), the vertical movement device (60a) is structured so as to be capable of lifting and lowering the plurality of supporting pins (52) simultaneously, and the push-in device (87) pushes-in one of the supporting pins (52) selected from among the plurality of supporting pins (52) lifted simultaneously by the vertical movement device (60a) into a corresponding one of the plurality of supporting holes (53).

11. The screen printer of claim 10, wherein the base (81) supports the supporting pin (52) lifted by the vertical movement device (60a) by moving horizontally.

12. The screen printer of claim 11, wherein the substrate supporting device (24) further comprises a packing (76) disposed in a lower portion of the supporting pin (52) and making contact with a sidewall of the supporting hole (53) and an air supply providing a lower portion or an upper portion of the supporting hole (53) with air.

13. The screen printer of claim 9, wherein the supporting block (51) is capable of sliding in a horizontal direction and comprises a plurality of supporting holes (53) to support the plurality of supporting pins (52) and an air supply conduits (56, 57), each of the supporting holes (53) comprising an upper hole (54) and a lower hole (55), the upper hole (54) being formed in an upper portion of the supporting block (51) and supporting the supporting pin (52) so as to allow the supporting pin (52) to slide vertically, the lower hole (55) being formed below the upper hole (54) and larger than the upper hole (54) in a cross-sectional area, the air supply conduits (56, 57) communicating with an upper portion or a lower portion of the lower hole (55), wherein each of the supporting pins (52) comprises a sliding portion (64), a lower intermediate portion (66), a central portion (67), an upper intermediate portion (68) and an extended portion (71), the sliding portion being disposed in a lower portion of the supporting pin (52) and configured to be able to slide vertically in the lower hole (55), the lower intermediate portion (66) being formed above the sliding portion (64) and smaller in cross-sectional area than the sliding portion (64), a space being formed between the lower intermediate portion (66) and a sidewall of the lower hole (55), the lower intermediate portion (66) sliding into the upper hole (54) when being lifted, the lower intermediate portion (66) being fitted to the upper hole (54), the central portion (67) being formed above the lower intermediate portion (66) and smaller in cross-sectional area than the lower intermediate portion (66), the upper intermediate portion (68) being formed above the central portion (67) and identical in cross-sectional shape to the lower intermediate portion (66), the extended portion (71) being formed above the upper intermediate portion (68) and smaller in cross-sectional area than the upper intermediate portion (68), and wherein the base (81) is disposed above the supporting block (51) and comprises a plurality of through-holes (82) formed so that each of the through-holes (82) corresponds to each of the supporting pins (52) respectively, each of the through-holes (82) comprising a hoisting portion (83) and a supporting portion (84), the hoisting portion (83) corresponding to the upper intermediate portion (68), the supporting portion (84) being formed continuous to the hoisting portion (83) and configured so as to support a lower end of the upper intermediate portion (68) when the supporting pin (52) is lifted.

14. The screen printer of claim 13, wherein the sliding portion (64) comprises a packing (76) making contact with a sidewall of the lower hole (55).

15. The screen printer of claim 13, wherein the supporting block (51) and the base (81) are divided into divided supporting blocks (51) and divided bases (81), respectively, and each of the divided supporting blocks (51) is provided with each of the vertical movement devices (60a-60g) and the air supply conduits (56, 57).

16. The screen printer according to any of claims 9 to 15, wherein the substrate supporting device (24) further comprises a sheet (85) disposed on the base (81) and having a plurality of through-holes (82) each corresponding to each of the supporting pins (52), respectively.
